# EUROPEAN PATENT SPECIFICATION

(11) **EP 1 873 841 B1**
(45) Date of publication and mention of the grant of the patent: **20.10.2010**
(21) Application number: 06730650.6
(22) Date of filing: 30.03.2006
(51) Int. Cl.: H01L 31/04, H01L 31/042

(54) **BACK-PROTECTIVE SHEET FOR SOLAR CELL AND SOLAR CELL MODULE EMPLOYING THE SAME**
RÜCKSEITENSCHUTZFILM FÜR EINE SOLARZELLE UND SOLARZELLENMODUL DAMIT
FEUILLE DE PROTECTION ARRIÈRE POUR CELLULE SOLAIRE ET MODULE DE CELLULES SOLAIRES L' UTILISANT

(30) Priority: 31.03.2005 JP 2005101264; 30.01.2006 JP 2006020347
(43) Date of publication of application: 02.01.2008
(73) Proprietor: Toppan Printing Co., Ltd., Tokyo 110-8560 (JP)
(72) Inventor: SHIMENO, Ikuno, c/o TOPPAN PRINTING CO., LTD.,, Tokyo; 1108560 (JP); TSUJII, Atsushi, c/o TOPPAN PRINTING CO., LTD.,, Tokyo; 1108560 (JP)
(74) Representative: TBK-Patent
(86) International application number: PCT/JP2006/306702
(87) International publication number: WO 2006/106844

(56) References cited:
- EP-A- 1 054 456
- JP-A- 2004 288 693
- JP-A- 2004 307 794
- JP-A- 2005 011 923
- JP-A- 2005 011 923

## Description

### TECHNICAL FIELD

The present invention relates to a back surface protective sheet for use in a solar cell and a solar cell module using the back surface protective sheet, which can endure a severe environment over a long period, in particular which can improve environmental resistance such as hydrolysis resistance or weather resistance and dimensional resistance, and in addition which excels in various characteristics such as heat resistance, moisture resistance, gas barrier characteristics, physical strength, and which can be produced at a very low cost.
Priority is claimed on Japanese Patent Application Nos. 2005-101264, filed March 31, 2005, and 2006-020347, filed January 30, 2006, the contents of which are incorporated herein by reference.

### BACKGROUND ART

Recently, as concerns increase regarding the issue of global warming, in order to control carbon dioxide emissions, various efforts have been continued. Increased consumption of fossil fuel has caused an increase of atmospheric carbon dioxide, and temperature of the earth by the greenhouse effect, which have seriously affected the global environment. As for alternative energy as a substitute for fossil fuel, various sources have been examined, in particular, the expected use photovoltaic (PV) power as a clean energy source has increased. A solar cell constitutes a core of the PV system which exchanges energy from sunlight with direct electricity, and a solar cell is made of a semiconductor. A solar cell element is not usually used as a single body, and in general, several pieces to dozens of pieces of solar cell elements are cabled in series or parallel and packaged in various ways, and unitized into one unit in order to protect the element over a long period, e.g. for approximately twenty years. The unit incorporated into this package is called a solar cell module, which is in general constituted from a front surface which receives sunlight and is covered by glass, a filler consisting of thermoplastic resin which fills gaps, and a back surface which is protected by a sheet made of a heat-resistant or weather-resistant plastic material.

Since these solar cell modules are used outdoors, the constitution and material construction thereof necessitate sufficient durability, and weather resistance. In particular, the back surface protective sheet is required to have a low moisture permeability as well as weather resistance. This is because output of the module per se may be affected in the case in which moisture permeated therethrough causes removal or discoloration of filler or corrosion of wiring.

Hitherto, a back surface protective sheet for use in a solar cell having a laminated construction which is produced by inserting an aluminum foil between two sheets of vinyl polyfluoride film (fluorine film) (made by DUPONT Co., Ltd., brand name: "TEDLER") has been widely used. However, this fluorine film has poor mechanical strength, and softens by heat ranging from 140 to 150°C from a heat process during the production of a solar cell module, and a projection of the solar cell element electrode part penetrates through the filler layer, and further penetrates through an internal fluorine film which constitutes the back surface protective sheet to come into contact with an aluminum foil in the back surface protective sheet, thereby causing short-circuit between the solar cell element and the aluminum foil thus affecting cell performance. In addition, a fluorine film is expensive and is an obstacle in reducing the cost of a solar cell module. Moreover, the fluorine film has a problem in that a poisonous gas may be generated during burning of the waste products after use.

In addition, since aluminum foil is used, there are problems in that during burning of the waste product after use, unburned metal products may clog at a grate (firebar) of the garbage furnace, and that the aluminum foil may be converted into alumina during the burning and absorb moisture when reclamation by filling-up of burning residue to generate harmful ammonia gas which has been adsorbed in alumina in the burning residue, and further, it is not easy to recover only aluminum foil without burning it.

EP1054456 relates to a protective sheet for a solar battery module comprises a weather-resistant sheet (1) of, for example, a fluorocarbon resin, and a deposited inorganic oxide thin film (2) formed on one of the surfaces of the weather-resistant sheet (1). A surface-treated layer (3) is formed in the weather-resistant sheet (1) to enhance adhesion between the weather-resistant sheet (1) and the deposited inorganic oxide thin film (2).

JP2005011923 relates to a rear surface protective sheet 1, 2 for solar cell comprises a laminate formed by laminating a white multilayer polyester film of polyester resin having an intrinsic viscosity of 0.6 (dl/g) or above and a cyclic trimer content of 0.5 wt% or less and including an intermediate foamed resin layer 32 on one or both surfaces of a deposition thin film where a deposition thin film layer 12 of an inorganic oxide of aluminium oxide or silicon oxide is formed on one side of a substrate film and heat shrinkage of the laminate is 0.6% or less in the flow direction and 0.1% or less in the width direction. A unitized solar cell module employs its rear surface protective sheet.

Patent documents are written below.
[Patent Document 1] Japanese Unexamined Patent Application, First Publication No.2002-26354.

### DISCLOSURE OF THE INVENTION

In order to solve the above problems, various substitute films such as a poly acrylic film, a polyvinyl chloride film, a poly ethylene terephthalate film, a polycarbonate film, etc. have been proposed as a back surface protective film for a solar cell. In these films, for example, a back surface sealing film for a solar cell using a polyethylene terephthalate (PET) film and a solar cell using the same have been proposed (Patent Document 1). This back surface sealing film (back surface protective sheet) for a solar cell uses a biaxially oriented PET film which has improved a problem of environmental resistance such as hydrolysis resistance or weather resistance unique to a PET film; however, the thermal shrinkage percentage of a biakially oriented PET film is large, in particular, there is a possibility that wiring may bend or a cell may shift during a large size solar cell module step. A thermal fixing process to perform an annealing treatment onto an oriented film is needed in the equipment for production, in order to solve a problem of the shrinkage of a film due to this thermal shrinkage percentage, which leads to an increase in cost, thereby causing a problem in that a cheap back surface protective sheet cannot be provided.

Thus, in the present state, a back surface protective sheet for use in a solar cell, which is capable of sufficiently satisfying various types of environmental resistance such as hydrolysis resistance and weather resistance, dimensional resistance, other characteristics such as thermal resistance, moisture resistance, gas-barrier characteristics and physical resistance, and being produced at a low cost has not yet been provided.

The present invention has been made in order to solve the above problems and it is an object of the present invention to provide a back surface protective sheet for use in a solar cell module and a solar cell module which can endure a severe environment over a long period, in particular which can improve environmental resistance such as hydrolysis resistance or weather resistance and dimensional resistance, and in addition which excels in various characteristics such as heat resistance, moisture resistance, gas barrier characteristics, physical strength, and which can be produced at a very low cost.

That is, in order to attain the above object, a first aspect of the present invention is a back surface protective sheet for use in a solar cell, including a non-oriented transparent polybutylene terephtalate film, an adhesive layer disposed onto the non-oriented transparent polybutylene terephtalate film, and a gas banter evaporated film having an evaporated layer formed by evaporating an inorganic oxide onto a base material, in which the gas barrier evaporated film is disposed on a solar cell element side.

A second aspect of the present invention is the back surface protective sheet for use in a solar cell as set forth in the first aspect, in which the non-oriented transparent polybutylene terephtalate film has at least a thermal shrinkage percentage of not more than 1.2% with respect to both the longitudinal direction of the film and the width direction of the film.

A third aspect of the present invention is the back surface protective sheet for use in a solar cell as set forth in the first aspect, in which the non-oriented transparent polybutylene terephthalate film has a crystallinity of not less than 20%, and a thermal shrinkage percentage of not more than 1.2% with respect to both the longitudinal direction of film and the width direction of film.

A fourth aspect of the present invention is the back surface protective sheet for use in a solar cell as set forth in any one of the first to the third aspects, in which the base material is a non-oriented transparent polybutylene terephtalate film.

A fifth aspect of the present invention is the back surface protective sheet for use in a solar cell as set forth in any one of the first to the third aspects, in which the gas barrier evaporated film has further a plastic film which is disposed onto a solar cell element side.

A sixth aspect of the present invention is the back surface protective sheet for use in a solar cell as set forth in any one of the first to the third aspects, in which the evaporated film is made of a mixture of one or more selected from the group consisting of aluminum oxide, silicon oxide and magnesium oxide.

A seventh aspect of the present invention is the back surface protective sheet for use in a solar cell as set forth in the fifth aspect, in which the plastic film is a non-oriented transparent polybutylene terephthalate film having a thermal shrinkage percentage of not more than 1.2% with respect to both the longitudinal direction of film and the width direction of film.

An eighth aspect of the present invention is the back surface protective sheet for use in a solar cell as set forth in any one of the first to the third aspects, in which the non-oriented transparent polybutylene terephthalate film contains an additive for coloration.

A ninth aspect of the present invention is the back surface protective sheet for use in a solar cell as set forth in any one of the first aspect to the third aspects, in which the non-oriented transparent polybutylene terephthalate film contains a coloring additive for whitening.

A tenth aspect of the present invention is the back surface protective sheet for use in a solar cell as set forth in any one of the first aspect to the third aspects, in which the non-oriented transparent polybutylene terephthalate film has a foaming layer therein and a white (opaque) appearance.
An eleventh aspect of the present invention is the back surface protective sheet for use in a solar cell as set forth in any one of the first to third aspects, in which the non-oriented transparent polybutylene terephthalate film contains a coloring additive to blacken.

### <Action>

In the present invention, since a back surface protective sheet for use in a solar cell is constituted from a non-oriented polybutylene terephthalate film as a main body, and a lamination of a gas barrier evaporated film consisting of an inorganic oxide and other plastic film thereon, it is possible to provide a back surface protective sheet for use in a solar cell and a solar cell module which can endure a severe environment over a long period, in particular which can improve environmental resistance such as hydrolysis resistance or weather resistance and dimensional resistance, and in addition which excels in various characteristics such as heat resistance, moisture resistance, gas barrier characteristics, physical strength, and which can be produced at a very low cost.

In accordance with the present invention, it has become possible to provide a back surface protective sheet for use in a solar cell and a solar cell module which can endure a severe environment over a long period, in particular which can improve environmental resistance such as hydrolysis resistance or weather resistance and dimensional resistance, and in addition which excels in various characteristics such as heat resistance, moisture resistance, gas barrier characteristics, physical strength, and which can be produced at a very low cost.

In addition, since the back surface protective sheet of the invention excels in dimensional resistance, and does not cause bending of wiring during production of a solar cell module and shift of cells, it is possible to increase the module size.

In addition, by using a non-oriented polybutylene terephtalate film as the back surface protective sheet of the present invention, a thermal fixing process in the conventional oriented film can be omitted, and hence it is possible to produce at a very low cost a back surface protective sheet which excels in dimensional resistance and which is not limited by film production equipment, and as a result, it is possible to reduce the cost of a solar cell module.

In addition, since the back surface protective sheet of the present invention uses no aluminum foil or fluorine film as a constitutional material, it is possible to provide a back surface protective sheet having few environmental stresses, taking into consideration the environment, such as waste treatment after use and safety.

The back surface protective sheet for use in a solar cell of the present invention is constituted from a gas barrier laminated film consisting of an evaporated thin film layer of an inorganic oxide consisting of at least aluminum oxide, silicon oxide, or a mixture thereof laminated onto one surface of a base material, and a non-oriented polybutylene terephtalate film layer having a crystallinity of not less than 20% and thermal shrinkage percentage of not more than 1.2% with respect to both the longitudinal direction of the film and width direction of the film, laminated onto the evaporated thin film layer surface or both surfaces of the gas barrier laminated film, and hence the back surface protective sheet of the present invention excels in various characteristics such as weather resistance, hydrolysis resistance, moisture resistance, dimensional resistance and electric insulation, and can be produced at a low cost. And the solar cell module unitized by using the back surface protective sheet for use in a solar cell such that the non-oriented polybutylene terephtalate film layer surface of the back surface protective sheet for use in a solar cell is disposed outside is hardly hydrolyzed by outer moisture, without causing strength deterioration, having excellent generation efficiency, excellent performance and is capable of enduring use for a long period, and reducing cost.

### BRIEF DESCRIPTION OF THE DRAWINGS

FIG. 1 is a sectional view showing an example of a constitution of a back surface protective sheet for use in a solar cell of the present invention.
FIG. 2 is a sectional view showing another example of a constitution of a back surface protective sheet for use in a solar cell of the present invention.
FIG 3 is a sectional view showing another example of a constitution of a back surface protective sheet for use in a solar cell of the present invention.
FIG. 4 is a sectional view showing a still another example of a constitution of a back surface protective sheet for use in a solar cell of the present invention.
FIG. 5 is a sectional view showing an example of a constitution of a gas barrier evaporated film which constitutes the back surface protective sheet for use in a solar cell.
FIG. 6 is a sectional view showing an example of a solar cell module using the back surface protective sheet for use in a solar cell of the present invention.
FIG. 7A is a side sectional view showing an embodiment of the back surface protective sheet for use in a solar cell of the present invention.
FIG. 7B is a side sectional view showing another embodiment of the back surface protective sheet for use in a solar cell.
FIG. 8A is a cross-sectional view showing an embodiment of a solar cell module which is unitized using the back surface protective sheet for use in a solar cell of the present invention.
FIG. 8B is a cross-sectional view showing another embodiment of a solar cell module.

### BEST MODE FOR CARRYING OUT THE INVENTION

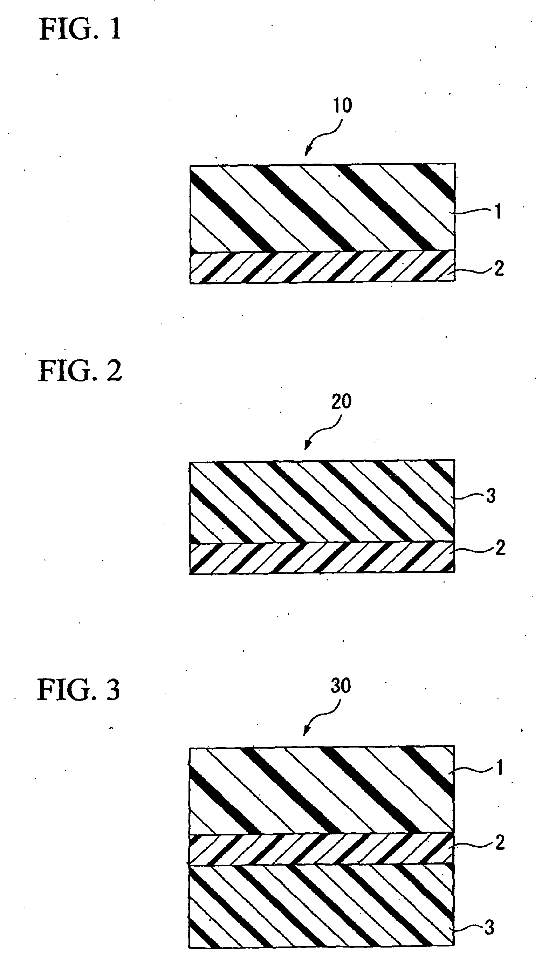

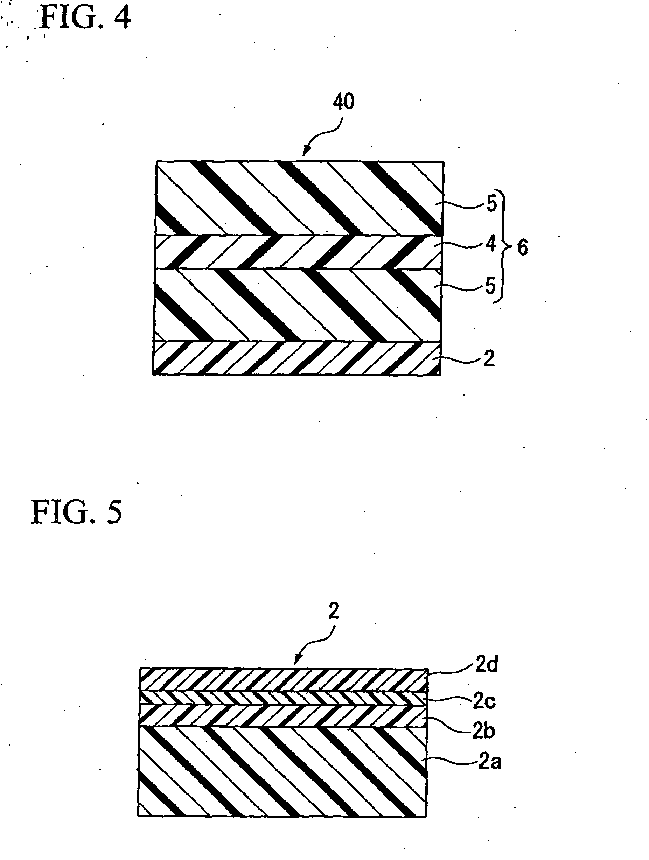

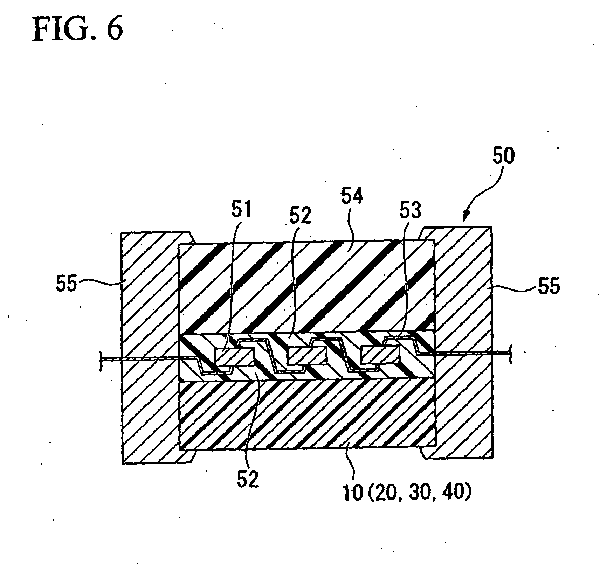

An explanation will be given with respect to embodiments of the present invention, referring to the drawings below. FIG. 1 is a sectional view which shows an example of a constitution of the back surface protective sheet for use in a solar cell of the present invention. FIG.2 is a sectional view which shows another example of a constitution of the back surface protective sheet for use in a solar cell of the present invention. FIG.3 is a sectional view which shows another example of a constitution of the back surface protective sheet for use in a solar cell of the present invention. FIG.4 is a sectional view which shows a still another example of a constitution of the back surface protective sheet for use in a solar cell of the present invention. FIG.5 is a sectional view which shows an example of a gas barrier evaporated film which constitutes the back surface protective sheet for use in a solar cell. FIG.6 is a sectional view which shows an example of a solar cell module using the back surface protective sheet for use in a solar cell of the present invention.

As shown in FIG. 1, a back surface protective sheet 10 for use in a solar cell as an example of the present invention is a back surface protective sheet having a two-layer structure, which is constituted from laminating a non-oriented transparent polybutylene terephtalate film 1 having a thermal shrinkage percentage of not more than 1.2% with respect to both the longitudinal direction of the film and width direction of the film, and a gas barrier evaporated film 2 consisting of an inorganic oxide with each other. And the gas barrier evaporated film 2 is disposed at a solar cell element side. It should be noted that, although it has been omitted in FIGs.1 to 6, an adhesive layer is formed between the non-oriented transparent polybutylene terephthalate film 1 and the gas barrier evaporated film 2. In addition, the gas barrier evaporated film 2 consists of two layers of a base material and a layer of an inorganic oxide evaporated thereon. As to each of the adhesive and the base material, a detailed explanation will be given later.

In addition, as shown in FIG.2, a back surface protective sheet 20 for use in a solar cell, which is another example of the present invention, is a back surface protective sheet having a two-layer constitution, in which a non-oriented white polybutylene terephtalate film 3 having a thermal shrinkage percentage of not more than 1.2% with respect to both the longitudinal direction of the film and a width direction of the film, and a gas barrier evaporated film 2 consisting of an inorganic oxide, are laminated. And the gas barrier evaporated film 2 is disposed at a solar cell element side.

In addition, a back surface protective sheet 30 for use in a solar cell as another example of the present invention is, as shown in FIG. 3, a back surface protective sheet having a three-layer constitution, in which each of a non-oriented transparent polybutylene terephtalate film 1 having a thermal shrinkage percentage of not more than 1.2% with respect to both the longitudinal direction of the film and a width direction of the film, a gas barrier evaporated film 2 consisting of an inorganic oxide, and a non-oriented white polybutylene terephtalate film 3 having a thermal shrinkage percentage of not more than 1.2% with respect to both the longitudinal direction of the film and a width direction of the film as a plastic film is laminated. And the non-oriented white polybutylene terephthalate film 3 is disposed at a solar cell element side.

In addition, a back surface protective sheet 40 for use in a solar cell as still another example of the present invention is, as shown in FIG.4, a back surface protective sheet having a constitution in which a polybutylene terephtalate laminated film 6 with a three-layer constitution in which transparent polybutylene terephtalate resin layers 5 and 5 are laminated respectively by a co-extrusion method onto both surfaces of a white polybutylene terephtalate resin layer 4 as an intermediate layer, having a thermal shrinkage percentage of not more than 1.2% with respect to both the longitudinal direction of the film and a width direction of the film, and a gas barrier evaporated film 2 consisting of an inorganic oxide. And the gas barrier evaporated film 2 is disposed at a solar cell element side.

As the polybutylene terephtalate (PBT) resin, a PBT resin of which an end carboxyl group concentration is controlled to be low is preferably used, because it is known that, in general, as the end carboxyl group concentration of polyesters such as a polybutylene terephtalate (PBT) increases, hydrolysis resistance thereof will deteriorate, and as the end carboxyl group concentration of PBT resin increases, the hydrolysis reaction rate under wet conditions and heating will increase, and as a result, molecular weight will decrease, which leads to deterioration of mechanical physical properties.

As a PBT resin having an improved hydrolysis resistance as such, for example, a PBT resin disclosed in Japanese Unexamined Patent Application, First Publication No.2004-307794 can be used, which is a polymer having a construction in which terephthalic acid unit and 1,4-butandiol unit constitute an ester bond, not less than 50 mol% of dicarboxylic acid unit consists of a terephthalic acid unit, and not less than 50 mol% of diol component consists of a 1,4-butanediol unit. The percentage of the terephthalic acid unit in the whole dicarboxylic acid unit is preferably not less than 70 mol%, more preferably not less than 80 mol%, particularly preferably not less than 95 mol%, and the percentage of 1,4-butane diol unit in the whole diol unit is preferably not less than 70 mol%, more preferably not less than 80 mol%, and particularly preferably not less than 95 mol%.

Dicarboxylic acid components other than terephthalic acid are not particularly limited, for example, aromatic dicarboxylic acid, such as phthalic acid, isophthalic acid, 4,4'-diphenyl carboxylic acid, 4,4'-diphenyl ether dicarboxylic acid, 4,4'-benzophenone dicarboxylic acid, 4,4'-diphenoxyethanedicarboxylic acid, 4,4'-diphenyl sulfone dicarboxylic acid, 2,6-naphthalene dicarboxylic acid,etc.; and alicyclic dicarboxylic acid such as 1,2-cyclohexane dicarboxylic acid, 1,3-cyclohexane dicarboxylic acid, 1,4-cyclohexane dicarboxylic acid, etc.; and aliphatic dicarboxylic acid such as malonic acid, succinic acid, glutaric acid, adipic acid, pimelic acid, suberic acid, azelaic acid, sebacic acid,etc. are exemplary. These dicarboxylic acid components may be introduced into a polymer framework as a dicarboxylic acid, or using dicarboxylic acid derivatives such as a dicarboxylic ester, dicarboxylic halide as a raw material.

There is no particular limitation with respect to diol components other than 1,4-butanediol, for example, aliphatic diol, such as ethylene glycol, diethylene glycol, polyethylene glycol, 1,2-propanediol,1,3-propanediol, polypropylene glycol, polytetramethylene glycol, dibutylene glycol, 1,5-pentanediol, neopentyl glycol, 1,6-hexanediol, 1,8-octane diol, etc.; alicyclic diol, such as 1,2-cyclohexanediol, 1,4-cyclohexanediol, 1,1-cyclohexane dimethylol, 1,4-cyclohexane dimethylol,etc.; and aromatic diol, such as xylylene glycol, 4,4'-dihydroxy biphenyl, 2,2-bis(4-hydroxyphenyl)propane, bis(4-hydroxyphenyl)sulfone, etc. are exemplary.

Moreover, a hydroxy carboxylic acid, such as lactic acid, glycolic acid, m-hydroxy benzoic acid, p-hydroxy benzoic acid, 6-hydroxy-2-naphthalene carboxylic acid, p-β-hydroxy ethoxy benzoic acid, etc.; a mono-functional component, such as alkoxy carboxylic acid, stearyl alcohol, benzyl alcohol, stearic acid, benzoic acid, t-butyl benzoic acid, benzoyl benzoic acid, etc.; a polyfunctional component of not less than trifunctional, such as tricarbaryl acid, trimerit acid, trimesic acid, pyromellitic acid, gallic acid, trimethylol ethane, trimethylol propane, glycerol, pentaerythritol, etc. can be used as a copolymerization component.

A PBT resin to be used in the present invention can be obtained by using a titanium catalyst as a catalyst when esterifying (or ester exchange reaction) 1,4-butane diol with terephtalic acid (or dialykyl terephtalate).
A non-oriented transparent PBT film or a non-oriented colored PBT film which contains an additive for coloring and foaming agent is prepared by sufficiently kneading a PBT resin composition which contains no additives such as additive for coloring, a foaming agent, etc., or while adding additives such as an additive for coloring, a foaming agent, etc. thereinto to prepare a PBT resin composition. And then, the resultant PBT resin composition thus prepared is put in an extruder, or T-die extruder, while controlling such that the thermal shrinkage percentage with respect to both the longitudinal direction and width direction should be not more than 1.2% by a film molding method such as an extrusion method, a T-die extrusion method, inflation molding, etc. to prepare a non-oriented transparent PBT film, a non-oriented colored PBT film, or a sheet. It should be noted that, in the present invention, it is also possible to produce a multi-layer-laminated PBT resin film or sheet consisting of the PBT resin composition prepared in the above, by co-extruding the PBT resin composition which contains no additives such as an additive for coloring, a foaming agent, etc., or the PBT resin composition which contains additives such as an additive for coloring, a foaming agent, etc., through T-die co-extrusion molding or inflation molding.

As a colorant for whitening of the additive for coloring in the above, for example, one or more kinds of white pigment of basic lead carbonate, basic lead sulfate, basic lead silicate, zinc oxide, zinc sulfide, lithopone, antimony trioxide, anatase type titanium dioxide, rutile type titanium dioxide, and others can be used. The added amount thereof ranges from 0.1 to 30 wt.% to PBT film, preferably from 0.5 to 10 wt.%.

By whitening, in the case in which it is disposed as a solar cell module, an effect to improve generation efficiency by reflecting or scattering sunlight can be realized.

In addition, as a black colorant of the additive for coloring, for example, one or more kinds of black pigment of carbon black (channel or furnace), black iron oxide, and others can be used. In the case in which a solar cell module is disposed onto for example a roof, an effect of providing a design and decoration which is compatible to the ambient environment is provided, and a black layer which is formed by a black colorant in the present invention may be any black layer of brown type, dark blue type, gray type, or any other blacking wash type black layer. In the above, the added amount of black colorant approximately ranges from 0.1 wt.% to 30 wt.% in the PBT resin composition, preferably ranges from 0.5 wt.% to 10 wt.%

It should be noted that, in the present invention, it is also possible to use a gray type achromatic color type dye or pigment obtained by mixing a white coloring additive and black coloring additive with each other.
In addition, saturated aliphatic hydrocarbons, such as propane gas, butane, etc.; inert gas such as carbon dioxide, nitrogen, etc.; halogenated hydrocarbon such as methyl chloride as the foaming agent is impregnated into PBT resin pellets and the resultant pellets are extruded to be foamed, thereby forming a foaming layer in a PBT film or a sheet. By forming a foaming layer in a PBT film or a sheet, it is possible to whiten it (opaque).

Although an example of laminating a non-oriented white polybutylene terephthalate film as a plastic film, i.e. the third layer in the back surface protective sheet having a three-layer constitution was illustrated, as shown in FIG.3, as long as it does not deviate from the spirit of the present invention, other generic plastic films, such as a film or a sheet consisting of ethylene-vinyl chloride copolymer, ionomer resin, ethylene-acrylic acid, or acid-modified polyolefin type resin, silicone resin, epoxy type resin, (meth)acryl type resin, or polycarbonate resin, can be also used, and it is not limited to a non-oriented white polybutyleneterephthalate film

Next, as the gas barrier evaporoted film consisting of an inorganic oxide to be used in the present invention as shown in FIGS, which is constituted by laminating a primer layer 2b which contains a complex of a silane coupling agent having organic functional groups or a hydrolysate of a silane coupling agent, a polyol, and an isocyanate compound, an inorganic oxide thin film layer 2c consisting of an inorganic oxide having a thickness ranging from 5 to 300 nm, and a gas barrier covering layer 2d onto at least one surface of a plastic film 2a, is used.

A detailed explanation of this gas barrier evaporated film 2 will be given below, referring to FIG. 5. As the plastic film base material 2a, for example, polyethylene terephthalate, polyacryl film, polycarbonate film, etc. are used, either oriented or non-oriented, and those having excellent mechanical strength and dimensional resistance are preferable. In particular, polyethylene terephthalate which has been oriented arbitrarily in a biaxial direction is preferable. In addition, onto the surface of the plastic base material 1, various well-known additives or stabilizers, such as an antistatic agent, ultraviolet ray inhibitor, a plasticizer, lubricant, etc. may be applied.

The thickness of the plastic film base material 2a is not particularly limited, however, the thickness practically ranges from 3 to 200 µm, and preferably ranges from 6 to 30 µm depending on use, in view of suitability as a back surface protective sheet, or processability in forming the primer layer 2b to be laminated, the inorganic oxide thin film layer 2c, and the gas barrier covering film layer 2d.

The primer layer 2b of the present invention is formed onto the plastic film base material 2a, which is formed in order to increase adherence between the plastic film base material 2a and the inorganic oxide thin film layer 2c consisting of an inorganic oxide, thereby preventing delamination, etc. In order to attain the object in the above, the primer layer 2b should be a complex of a silane coupling agent having organic functional groups, or hydrolysate thereof, a polyol, and an isocyanate compound, etc.

In addition, a detailed explanation will be given, with respect to a complex which constitutes the primer layer 2b. As an example of the silane coupling agent, a silane coupling agent containing arbitrary organic functional groups may be used, for example, a silane coupling agent, such as, vinyltrimethoxysilane, γ-chloropropyl methyldimethoxysilane, γ-chloropropyltrimethoxysilane, glycidoxypropylpropyltrimethoxysilane, γ-methacryloxypropyltrimethoxysilane, γ-methacryloxypropylmethyl dimethoxysilane, etc., and one or more kinds of hydrolysate thereof may be used.

In addition, in these silane coupling agents, those having a functional group which reacts with a hydroxyl group or polyol or isocyanate group of an isocyanate compound are particularly preferable. For example, those containing an isocyanate group, such as γ-isocyanatepropyltriethoxysilane and γ-isocyanatepropyltrimethoxysilane; those containing a mercapto group, such as γ-mercaptopropyltriethoxysilane; and those containing an amino group, such as γ-aminopropyltriethoxysilane, γ-aminopropyltrimethoxysilane, N-β-(aminoethyl)-γ-aminopropyltriethoxysilane, and γ-phenylaminopropyltrimethoxysilane are exemplary. In addition, one or more of those containing an epoxy group such as γ-glycidoxypropylmethoxysilane, β-(3,4-epoxycyclohexyl)ethyltrimethoxysilane, etc., and those obtained by adding alcohol, etc. to a silane coupling agent, such as vinyltrimethoxysilane, vinyltris(β-methoxyethoxy)silane, etc. to add a hydroxyl group, may be used.

In these silane coupling agents, an organic functional group present at one end thereof exhibits an interaction in a complex consisting of a polyol and an isocyanate compound, or by using a silane coupling agent which contains a functional group which reacts with a hydroxyl group of polyol or an isocianate group of an isocianate compound to give a covalent bond, thereby forming a stronger primer layer, whereas an alkoxy group present at the other end or silanol group derived from hydrolysis of the alkoxy group exhibits a high adherence to inorganic oxide by a strong interaction with metal contained in the inorganic oxide or hydroxyl group having a high polarity on the surface of the inorganic oxide, thereby providing target physical properties. Therefore, it is also possible to use one which is obtained by hydrolyzing a silane coupling agent together with metal alkoxide as the primer layer. In addition, the alkoxy group of the silane coupling agent may be a chloro group, acetoxy group, etc., and if these alkoxy group, chloro group, acetoxy group, etc. are those which are hydrolyzed to form a silanol group, then they can be used in the complex.

In addition, a polyol has two or more hydroxyl groups at the end of polymer, and is reacted with an isocyanate group of an isocyanate compound which is to be added later. As such a polyol, a polyol produced by polymerizing an acrylic acid derivative monomer, or an acryl polyol produced by copolymerizing an acrylic acid derivative monomer with the other monomer is preferable. In particular, an acrylic polyol produced by polymerizing an acrylic acid derivative monomer such as ethymethacrylate, hydroxylethylmethacrylate, hydroxyl propylmethacrylate, hydroxybutylmethacrylate, etc., and acryl polyol produced by copolymerizing the acrylic acid derivative with the other monomer such as styrene, etc. are preferable. In addition, hydroxyl value of the acryl polyol preferably ranges from 5 to 200 (KOH mg/g), taking the reactivity to isocyanate compound and compatibility with the silane coupling agent into consideration.

The compounding ratio between an acryl polyol and a siliane coupling agent preferably ranges from 1/1 to 1000/1 in terms of weight ratio, and more preferably ranges from 2/1 to 100/1. A solvent for dissolving or diluting is not particularly limited, as long as it can dissolve or dilute, for example, those in which esters such as ethyl acetate, butyl acetate, etc.; alcohols such as methanol, ethanol, isopropylalcohol, etc.; ketones such as methylethylketone, etc.; and aromatic hydrocarbons such as toluene, xylene, etc. are compounded singly or arbitrary. However, in the case in which an aqueous solution of hydrochloric acid, etc. is used in order to hydrolyze a silane coupling agent, it is preferable to use a solvent in which alcohols such as isopropyl alcohol as a co-solvent and ethyl acetate as a polar solvent are present in an arbitrary ratio.

Moreover, an isocyanate compound is added in order to increase adherence to a plastic base material or inorganic oxide by a urethane bond derived from the reaction with polyols such as acryl polyol, etc., and an isocyanate compound acts mainly as a cross-linking agent or a hardening agent. As a specific example of an isocyanate compound which exhibits the above function, one or more of a monomer, a polymer, or a derivative of aromatic ones such as tolylenediisocyanate (TDI), diphenyl methane diisocyanate (MDI), an aliphatic one such as xylene diisocyanate (XDI) and hexamethylene diisocyanate (HMDI), isophorone diisocyanate (IPDI) can be used.

Here, the compounding ratio between the acrylic polyol and isocyanate compound is not particularly limited, however, if the amount of isocyanate compound is too small, then it may lead to a poor hardening, whereas if the amount of isocyate is too large, then it may lead to blocking causing a problem in processing. So, the compounding ratio between the acrylic polyol and isocyanate compound is preferably such that the NCO group derived from isocyanate compound is not more than 50 times the OH group derived from acrylic polyol, more preferably such that the NCO group is equivalent to the OH group. As for a method of mixing, well-known method can be used, and is not particularly limited.

The primer layer 2b is formed by preparing a complex solution in which a silane coupling agent, a polyol, an isocyanate compound is mixed at an arbitrary concentration, and then coating the resultant complex solution onto the plastic film base material 2a, and thereafter drying and hardening. Specifically, a primer agent which constitutes the primer layer 2b is prepared by mixing a silane coupling agent with a polyol, adding a solvent and a diluent thereto to dilute the mixture to be an arbitrary concentration, and thereafter mixing the resultant mixture with an isocyanate compound. Besides the above method, there is a method which includes previously mixing a silane coupling agent with a polyol in a solvent to react the silane coupling agent with the polyol beforehand, adding a solvent and/or a diluent to the resultant mixture to dilute at an arbitrary concentration, and thereafter adding the resultant mixture to an isocyanate compound.

To the above primer agent, various additives, for example, a hardening accelerator such as a tertiary amine, an imidazole derivative, a metal salt compound of carboxylic acid, a quaternary ammonium salt, a quaternary phosphonium salt, etc.; antioxidants such as phenol type, sulfur type, phosphate type, etc.; a leveling agent, a flow adjuster, a catalyst, bridging accelerator, a filler, etc. can be added.

The primer layer 2b is formed by coating a primer agent onto the plastic film base material 2a using a well-known printing method such as an offset printing method, a gravure printing method, a silk-screen printing method, or a well-known application style such as roll-coat, a knife edge coat, a gravure coat, etc., and thereafter drying the resultant coated film and removing solvent to harden it.

The thickness of the primer layer 2b is not limited particularly, as long as it is possible to form a coating uniformly, however, in general the thickness preferably ranges from 0.01 to 2 µm. If the thickness is less than 0.01 µm, then a uniform coated film is hardly obtainable and the adherence may deteriorate. Whereas if the thickness is more than 2 µm, then it is not possible to maintain flexibility in the coated film because of the large thickness, and there is a possibility that cracks generate in the coated film by outer factor, it is not preferable. Particularly preferably the thickness ranges from 0.05 to 0.5 µm.

Next, the inorganic oxide thin film layer 2c consisting of an inorganic oxide consists of an evaporated film of an inorganic oxide such as aluminum oxide, silicon oxide, tin oxide, magnesium oxide or a mixture thereof, as long as it has transparency, and gas barrier characteristics to oxygen, water steam, etc.
Of these, aluminum oxide and silicon oxide are particularly preferable. However, the inorganic oxide thin film layer 2 of the present invention is not limited to the above inorganic oxides, and any material conforming to the above condition can be used.

Although the optimum condition differs depending on the kind, and constitution of an inorganic oxide to be used, in general, the thickness of the inorganic oxide thin film layer 2c preferably ranges from 5 to 300 nm, and the value is selected suitably. If the thickness is less than 5 nm, then a uniform film may not be obtainable or the thickness may be insufficient, and as a result, it may not serve as a gas barrier material sufficiently. In addition, if the thickness is more than 300 nm, then it is difficult to maintain flexibility in the inorganic oxide thin film layer, and as a result there is a possibility that cracks generate in the inorganic oxide thin film layer due to outer factors such as bending or stretching after film formation. Preferably the thickness ranges from 10 to 150 nm.

Various means for forming the inorganic oxide thin film layer 2c on the primer layer 2b are possible, however, it is common to form by a vacuum deposition method. A sputtering method, ion plating method, plasma vapor deposition method (CVD) can be used as means other than this vacuum deposition method. However, taking productivity into consideration, vacuum deposition method is the best at present. As a means for heating the vacuum deposition apparatus using the vacuum deposition method, either an electron beam heating method, a resistance heating method, or an induction heating method may be used suitably. In addition, a plasma assist method and an ion beam assist method can be used in order to improve the adherence between the inorganic oxide thin film layer and the plastic base material and minuteness of the inorganic oxide thin film layer. In addition, a reaction deposition which blows oxygen during deposition may be performed in order to increase transparency of the inorganic oxide thin film layer.

A gas barrier coated film layer 2d disposed onto the inorganic oxide film thin layer 2c is a layer to protect the inorganic oxide thin film layer 2c and impart a higher gas barrier characteristics.

As a formation material to impart higher gas barrier characteristics of the above gas barrier coated film layer 2d, for example, one consisting of a water-soluble polymer and one or more of metal alkoxide and/or a hydrolysate thereof, and further, one produced by applying a solution consisting of any one selected from the group consisting of the metal alkoxide, tetraethoxysilane, triisopropoxy aluminum, and a mixture thereof can be used. As another example of a coated film layer which imparts a high gas barrier characteristic, one consisting of a water-soluble polymer and silver chloride, and further one in which the above water-soluble polymer is one applying a solution consisting of polyvinylalcohol thereto can be used. Specifically, one produced by dissolving a water-soluble polymer and tin chloride in an aqueous type solvent (water or water/alcohol mixture) to form an aqueous solution, by adding a metal alkoxide to the above solution directly, or treated one previously treated by hydrolysis to form a solution, then coating the resultant solution onto the inorganic oxide thin film layer 2c, and thereafter heating and drying it. A further detailed explanation will be given with respect to each of components which form the gas barrier coated film layer 2d.

As a specific example of a water-soluble polymer which is used for forming the gas barrier coated film layer 2d in the present invention, polyvinyl alcohol, polyvinyl pyrrolidone, starch, methyl cellulose, carboxy methyl cellulose, sodium alginate, etc. are exemplary. In particular, polyvinyl alcohol (PVA) most excels in gas barrier characteristics. PVA referred to here is in general use and is produced by saponifying poly vinyl acetate, which includes a so-called partially saponified PVA having several ten % of a residual acetic acid group and a complete PVA having several % of a residual acetic acid group, that is, PVA is not particularly limited.

In addition, tin chloride may be tin chloride (SnCl₂), tin tetrachloride (SnCl₄), or a mixture thereof, and either an anhydride or hydrate thereof may be used.

Moreover, a metal alkoxide is one which can be expressed by a general formula M (OR) ₙ (M: metal such as Si, Ti, Al, Zr; R: alkyl groups such as CH₃, C₂H₅, etc.) such as tetraethoxysilane [Si (OC₂H₅)₄], triisopropoxy aluminum [Al (O-2'-C₃H₇)₃], etc. Among these, tetraethoxy silane, triisopropoxy aluminum are preferable, because they are relatively stable even in an aqueous solvent after hydrolysis.

It is possible to form the gas barrier coated film layer 2d by using each of components in the above alone or two or more of in combination, and further additives such as an isocyanate compound, silane coupling agent, dispersing agent, stabilizer, viscosity adjuster, colorant, etc. may be added within the range in which gas barrier characteristics do not deteriorate.

For example, an isocyanate compound which is added to the gas barrier coated film layer 2d is one which contains two or more isocyanate groups (NCO group) in one molecule, for example, a monomer, polymer, or derivative thereof of tolylene diisocyanate (TDI), triphenylmethane triisocyanate (TTI), tetramethyl xylene diisocyanate (TMXDI).

As an application method of a coating agent to form the gas barrier coated film layer 2d, conventionally well-known means such as a dipping method, roll coating method, screen printing method, spray method can be used. In addition, the thickness of a coated film layer is varied depending on the kind of the coating agent to form a coated film layer and processing condition, however, the thickness after drying should be not less than 0.01 µm. If the thickness is more than 50 µm, then cracks easily occur, and hence the thickness preferably ranges from 0.01 to 50 µm.

As a method for laminating films which constitute the back surface protective sheet for use in a solar cell of the present invention, a well-known method such as dry lamination method, extrusion lamination method can be used. As an adhesive for a dry lamination method, it is necessary that adhesive strength does not cause delamination by deterioration even after outdoor use for a long period, and that the adhesive will not cause yellow discoloration, for example, polyurethane type adhesive, etc. can be used. The above adhesives can be applied by, for example, a roll-coat method, a gravure roll coat method, kiss-coat method, other coating methods, or printing method, and the applied amount preferably ranges from approximately 0.1 to 10 g/m²(dry condition).

Next, an explanation will be given with respect to a method for producing a solar cell module using the back surface protective sheet for use in a solar cell of the present invention, referring to FIG. 6. As such a process, a well-known method, for example, an ordinary molding method such as lamination method which includes laminating a back surface protective sheet 54 for use in a solar cell, a filler layer 52, a solar cell element 51 as a photovoltaic element in which wiring 53 is installed, a filler layer 52 and a back surface protective sheet 10(20, 30, 40) of the present invention in turn, and further if necessary, laminating another material arbitrarily therebetween, and thereafter unifying these by a vacuum suction and heating and pressing, is utilized to perform heat and press molding each of layers in the above, and then installing a frame (a spacer) 55, thereby producing a solar cell module.

As a normal back surface protective sheet 54 for use in a solar cell which constitutes the above solar cell module, it is necessary to have an excellent scratch resistance and excellent impact resistance, in order to impart sunlight permeability, resistance, weather resistance, heat resistance, light resistance, water resistance, moisture resistance, anti-fouling property, excellent physical or chemical strength, excellent toughness, excellent durability and to protect a solar cell element as a photovoltaic element. As a surface protective sheet in the above, specifically, a well-known glass plate, in addition, for example, various kinds of polymer or sheet such as polyamide type resin (various kinds of nylon), polyester type resin, cyclic polyolefin type resin, polystyrene type resin, (meth)acryl type resin, polycarbonate type resin, acetal type resin, etc. can be used.

The filler layer 52, which is laminated under the back surface protective sheet 54 for use in a solar cell which constitutes the above solar cell module, should have transparency because sunlight enters and permeates therethrough and is absorbed, adherence to the surface protective sheet and the back surface protective sheet, theremoplasticity to maintain smoothness of the surface of the solar cell element as a photovoltaic element, and excellent in scratch resistance and impact strength, to protect the solar cell element as a photovoltaic element. Specifically, as the above filler layer, for example, one or more of a mixture of ethylene-vinyl acetate copolymer, ionomer resin, ethylene-acrylic acid or acid-denaturated polyolefin type resin, polyvinyl butyral resin, silicone type resin, epoxy type resin, (meth)acryl type resin, and others can be used. It should be noted that in the present invention, as a filler on the incident side of sunlight, an ethylene-vinyl acetate type resin is preferable, taking weather resistance such as light resistance, heat resistance, water resistance, etc., into consideration.

As the solar cell element 51 as a photovoltaic element which constitutes the above solar cell module, those which are conventionally well-known, for example, crystal silicon solar cell elements such as a monocrystal silicon type solar cell element, polycrystal silicon type solar cell element, etc.; amorphous silicon solar cell element consisting of a single junction type, or tandem construction type, etc.; III-V group compound semiconductor solar cell element such as gallium arsenic (GaAs) or indium phosphorus (InP), etc.; II-VI group compound semiconductor solar cell element such as cadmium tellurium (CdTe) or copper indium selenide (CuInSe₂), etc.; an organic solar cell element, and others can be used. In addition, a thin film polycrystalline silicon solar cell element, a thin film microcrystalline silicon solar cell element, a hybrid element consisting of a thin film crystalline silicon solar cell element and an amorphous silicon solar cell element, etc. can be used.

A filler layer 52 which is laminated under the photovoltaic element 51 which constitutes the above solar cell module is required to have adherence to a back surface protective sheet, be made of the same material as the filler layer which is laminated under the above surface protective sheet for use in a solar cell, have thermoplasticity in order to serve to maintain smoothness of the back surface of the solar cell element as a photovoltaic element, and excel in scratch resistance and impact strength in order to protect the solar cell element as a photovoltaic element.

An aluminum mold member is generally used for the frame (a spacer) 55 of the above solar cell module.

Specific Examples of the present invention will be explained below.

### [Example 1]

A back surface protective sheet for use in a solar cell of the present invention having the following constitution was produced, which has constituted from a non-oriented transparent polybutyleneterephthalate (PBT) film having a thickness of 50 µm formed by a T-die method, and the following gas barrier evaporated film which was laminated onto one surface of the non-oriented transparent polybutyleneterephthalate (PBT) film, while directing the plastic film base material side thereto.
A non-oriented transparent PBT film (50 µm) / a gas barrier evaporated film

### <Gas barrier evaporated film>

A gas barrier evaporated film having a constitution shown in FIG. 5 was produced. Onto one surface of a biaxially oriented polyethyleneterephthalate (PET) film having a thickness of 12 µm as a plastic base material 2a, a primer agent A as a primer layer 2b was formed so as to have a thickness of 0.2 µm (dry thickness) by a gravure coating method. Next, onto the primer layer 2b, by means of a vacuum evaporation deposition apparatus using an electron beam heating method, metallic aluminum was evaporated and oxygen gas was introduced there, thereby depositing aluminum oxide (alumina) to form an inorganic oxide thin film layer 2c having a thickness of 20 nm. And further, a coating agent having the following composition was applied thereon using a gravure coater, and dried at 100°C for 1 minute using a dryer to obtain a gas barrier evaporated film with a coated film layer 2d having a thickness of 0.3 µm thereon. As the coating agent, a mixture of a liquid (1) and a liquid (2) mixed at a ratio (wt%) of liquid (1)/liquid (2) = 60/40 was used. Here, the liquid (1) was a hydrolysate solution having a solid content of 3 wt.% (SiO₂ converted score) obtained by adding 89.6 g of hydrochloric acid (0.1N) to 10.4 g of tetraethoxysilane, and then stirring for 30 minutes to hydrolyze, and the liquid (2) was a mixture of 3 wt.% polyvinyl alcohol aqueous/isopropyl alcohol solution (water:isopropylalcohol =90:10 by weight)

### <Primer agent A>

In a dilution solvent (ethyl acetate), 5 parts by weight of acryl polyol was added to 1 part by weight of y-isocyanate propyl trimethyl silane, and mixed. Next, a mixed solution, in which toluidine isocyanate (TDI) as an isocyanate compound was added to acryl polyol such that an NCO group was equivalent to OH group of the acryl polyol was diluted to have a concentration of 2%, and this solution was called "primer agent A".

### [Example 2]

A back surface protective sheet for use in a solar cell having the following constitution of the present invention was produced by the same way as in Example 1, with the exception of using a non-oriented white PBT film in which a white pigment was kneaded which was formed by a T-die method having a thickness of 50 µm, for the non-oriented transparent PBT film formed by a T-die method.
A white pigment kneaded non-oriented white film PBT film (50 µm)/a gas barrier evaporated film

### [Example 3]

A back surface protective sheet for use in a solar cell having the following constitution of the present invention was produced by the same way as in Example 1, with the exception of using a non-oriented foaming PBT film which was formed by a T-die method having a thickness of 75 µm instead of the non-oriented transparent PBT film formed by a T-die method having a thickness of 50 µm.
A non-oriented foaming PBT film (75 µm)/a gas barrier evaporated film

### [Example 4]

The white pigment kneaded non-oriented white PBT film produced in the Example 2 was further laminated onto the side of the back surface protective sheet produced in Example 1 to produce a back surface protective sheet for use in a solar cell of the present invention having the following constitution.
A non-oriented transparent PBT film (50 µm)/a gas barrier evaporated film/a white pigment kneaded non-oriented white PBT film (50 µm)

### [Example 5]

A back surface protective sheet for use in a solar cell having the following constitution of the present invention was produced by the same way as in Example 1, with the exception of using a non-oriented PBT laminated film having a total thickness of 100 µm and a three-layer constitution, which was constituted from a non-oriented white PBT resin layer in which a white pigment was kneaded as an intermediate layer and two transparent PBT resin layers each of which was laminated onto the front and the back surface of the intermediate layer by co-extrusion method.
A non-oriented PBT laminated film having a three-layer constitution (100 µm)/a gas barrier evaporated film

### [Example 6]

A back surface protective sheet for use in a solar cell having the following constitution of the present invention was produced by the same way as in Example 1, with the exception of using a non-oriented transparent PBT film which was formed by an inflation method having a thickness of 50 µm instead of the non-oriented transparent PBT film formed by a T-die method having a thickness of 50 µm.
A non-oriented transparent PBT film (50 µm)/a gas barrier evaporated film

### [Example 7]

A back surface protective sheet for use in a solar cell having the following constitution of the present invention was produced by the same way as in Example 1, with the exception of using a non-oriented white PBT film in which a white pigment was kneaded and which was formed by an inflation method having a thickness of 50 µm instead of the non-oriented transparent PBT film formed by a T-die method having a thickness of 50 µm.
A non-oriented white PBT film in which a white pigment was kneaded (50 µm)/a gas barrier evaporated film

### [Example 8]

A back surface protective sheet for use in a solar cell having the following constitution of the present invention was produced by the same way as in Example 1, with the exception of using a non-oriented white PBT film in which a white pigment was kneaded and which was formed by an inflation method having a thickness of 75 µm instead of the non-oriented transparent PBT film formed by a T-die method having a thickness of 50 µm.
A non-oriented white PBT film in which a white pigment was kneaded (75 µm)/a gas barrier evaporated film

### [Example 9]

A back surface protective sheet for use in a solar cell having the following constitution of the present invention was produced by the same way as in Example 1, with the exception of using a non-oriented white PBT film in which a white pigment was kneaded and which was formed by an inflation method having a thickness of 250 µm instead of the non-oriented transparent PBT film formed by a T-die method having a thickness of 50 µm.
A non-oriented white PBT film in which a white pigment was kneaded (250 µm)/a gas barrier evaporated film

### [Example 10]

As a Comparative Example for comparing with the back surface protective sheet for use in a solar cell of the present invention with respect to performance thereof, a back surface protective sheet for use in a solar cell having the following constitution of the present invention was produced by the same way as in Example 1, with the exception of using a biaxially oriented white polyethyleneterephthalate (PET) film in which a white pigment was kneaded and which was formed by a T-die biaxially stretching method having a thickness of 50 µm instead of the non-oriented transparent PBT film formed by a T-die method having a thickness of 50 µm.
A biaxially oriented white PET film in which a white pigment was kneaded (50 µm)/a gas barrier evaporated film

### [Example 11]

As a Comparative Example for comparing with the back surface protective sheet for use in a solar cell of the present invention with respect to performance thereof, a back surface protective sheet for use in a solar cell having the following constitution of the present invention was produced by the same way as in Example 1, with the exception of using a biaxially oriented heat-resistant PET film which was formed by a T-die biaxially-stretching method having a thickness of 50 µm instead of the non-oriented transparent PBT film formed by a T-die method having a thickness of 50 µm.
A biaxially oriented heat-resistant PET film (50 µm)/a gas barrier evaporated film

### [Example 12]

As a Comparative Example for comparing with the back surface protective sheet for use in a solar cell of the present invention with respect to performance thereof, a back surface protective sheet for use in a solar cell having the following constitution of the present invention was produced by the same way as in Example 1, with the exception of using a biaxially oriented anneal PET film which was formed by a T-die biaxially-stretching method having a thickness of 50 µm instead of the non-oriented transparent PBT film formed by a T-die method having a thickness of 50 µm.
A biaxially oriented anneal PET film (50 µm)/a gas barrier evaporated film

### [Example 13]

As a Comparative Example for comparing with the back surface protective sheet for use in a solar cell of the present invention with respect to performance thereof, a back surface protective sheet for use in a solar cell having the following constitution in which a fluorine film ("TEDLER" produced by Dupont Co., Ltd.) which was formed by T-die method having a thickness of 38 µm was further laminated onto the gas barrier evaporated film side of the back surface protective sheet produced by the same way as in Example 1 was produced, using the fluorine film ("TEDLER") which was formed by a T-die method having a thickness of 38 µm instead of the non-oriented transparent PBT film formed by a T-die method having a thickness of 50 µm in Example 1.
A fluorine film (3 8 µm)/a gas barrier evaporated film/a fluorine film (38 µm)

### [Example 14]

As a Comparative Example for comparing with the back surface protective sheet for use in a solar cell of the present invention with respect to performance thereof, a back surface protective sheet for use in a solar cell having the following constitution of the present invention was produced by the same way as in Example 1, with the exception of laminating only a PET film having a thickness of 12 µm without forming the gas barrier evaporated film, instead of the gas barrier evaporated film.
A non-oriented transparent PBT film (50 µm)/a biaxially oriented PET film (12 µm)

### [Example 15]

As a Comparative Example for comparing with the back surface protective sheet for use in a solar cell of the present invention with respect to performance thereof, a back surface protective sheet for use in a solar cell having the following constitution of the present invention was produced by the same way as in Example 1, with the exception of using a biaxially oriented transparent PET film which was formed by a T-die biaxial-stretching method having a thickness of 250 µm instead of the non-oriented transparent PBT film formed by a T-die method having a thickness of 50 µm.
A biaxially oriented transparent PET film (250 µm)/a gas barrier evaporated film.

With respect to the back surface protective sheet for use in a solar cell produced in Examples 1 to 15, thermal shrinkage percentage and hydrolysis resistance were evaluated based on the following evaluation methods. The results are shown in Table 1.

### <Evaluation method of the thermal shrinkage percentage>

A reference line was marked on a PBT film beforehand, and the dimension was measured, and thereafter it was held in an atmosphere of 150°C for 30 minutes, and then the dimension after heating was measured to obtain the thermal shrinkage percentage (%).

### <Evaluation method of hydrolysis resistance >

A film was stored under a high temperature and a high humidity of 85°C×85% RH×1,000 hours, and tensile strength, extension percentage were measured, and retention when initial breaking strength was regarded as 100% was evaluated by the following three-step evaluation.
A: OK ... retention was not less than 70%
B: ... retention ranged 50 to 70% or more
C: NG ... retention was not more than 50%
In addition, using an ethylene-vinyl acetate copolymer(EVA) sheet of a standard cure type having a thickness of 600 µm as a solar cell module filling, using a polycrystal silicon as a solar cell, onto a tempered glass of A4 size, EVA seat, a battery cell, a back surface protective sheet were laminated sequentially under a condition of a preliminary heating temperature of 40°C×5 minutes, and vacuum suction (0.5 atm) for 5 minutes at 150°C×holding for 5 minutes, and thereafter it was held at 150°C for 30 minutes to allow the reaction to proceed, and the resultant laminate was framed by an aluminum frame to produce a solar cell module for a test. And thereafter, a promoting test was performed for 1000 hours under a condition of 85°C×85% RH, and then a retention to an initial output was measured in accordance with JISC-8913 to evaluate a solar cell output and appearance. The results are shown in Table 1.

**Table 1**

| Kind | Example No. | Shrink percentage of PBT film (%) | | Hydrolysis resistance | Solar cell output retention (%) | Module appearance |
|---|---|---|---|---|---|---|
| | | Longitudinal direction | Width direction | | | |
| The Present Invention | Example 1 | 0.2 | 0.1 | A | 97.5 | OK |
| | Examples 2 | 0.5 | 0.3 | A | 98.2 | OK |
| | Example 3 | 0.5 | 0.3 | A | 100.1 | OK |
| | Example 4 | 0.3 | 0.2 | A | 98.5 | OK |
| | Examples 5 | 0.3 | 0.2 | A | 97.4 | OK |
| | Example 6 | 0.3 | 0.2 | A | 99.1 | OK |
| | Example 7 | 0.3 | 0.2 | A | 98.2 | OK |
| | Example 8 | 1.0 | 0.7 | A | 98.0 | OK |
| | Example 9 | 1.1 | 0.5 | A | 98.5 | OK |
| Comparative Example | Example 10 | 1.5 | 1.0 | C | 92.1 | NG Wiring shift |
| | Example 11 | 1.5 | 0.7 | B | 96.2 | NG Wiring shift |
| | Example 12 | 0.3 | 0.2 | B | 98.5 | OK |
| | Example 13 | 1.5 | 1.0 | A | 97.3 | NG Wiring bend |
| | Example 14 | 0.5 | 0.4 | A | 87.0 | OK |
| | Example 15 | 2.1 | 0.6 | C | 90.5 | NG Cell shift EVA baring |

| | | | | | | |
|---|---|---|---|---|---|---|
| A= OK: retention was not less than 70% B= : retention ranged 50 to 70% C= NG: retention was not more than 50% | | | | | | |

As is clear from Table 1, each of the back surface protective sheets for use in a solar cell of the present invention produced in Examples 1 to 9 has particularly low hydrolysis resistance and thermal shrinkage percentage, and excellent dimension resistance. On the other hand, each of the back surface protective sheets for use in a solar cell produced in Examples 10 and 11 as Comparative Examples for comparing the performance with the back surface protective sheet for use in a solar cell of the present invention has a large hydrolysis resistance and a poor dimensional resistance, and caused a wiring shift. And further, the back surface protective sheet for use in a solar cell produced in Example 12 as a Comparative Example has a small thermal shrinkage percentage, however, hydrolysis resistance is poor. In addition, the back surface protective sheet for use in a solar cell produced in Example 13 as a Comparative Example excels in hydrolysis resistance because it uses a PBT film as a film base material, however, the thermal shrinkage percentage is large, and dimensional resistance is poor, and caused a wiring bend. In addition, the back surface protective sheet for use in a solar cell produced in Example 14 as a Comparative Example excels in hydrolysis resistance similarly to Example 13, and excels in thermal shrinkage percentage, however, it clearly has a problem in gas barrier characteristics because it has no gas barrier alumina evaporated layer. In addition, the back surface protective sheet for use in a solar cell produced in Example 15 as a Comparative Example has a large hydrolysis resistance and a large thermal shrinkage percentage causing a problem in dimensional resistance and a cell shifting and EVA baring.

Each of the back surface protective sheet for use in a solar cell of the present invention produced in Examples 1 to 9 has a constitution which consists mainly of a non-oriented PBT film, and further a gas barrier evaporated film consisting of an inorganic oxide and the other plastic film laminated thereon, and hence particularly excels in environmental resistance such as hydrolysis resistance, weather resistance, etc., and further excels in dimensional resistance having a thermal shrinkage percentage with respect to both the longitudinal direction of the film and width direction of the film which are controlled to be not more than 1.2%. Therefore, it is possible to provide a back surface protective sheet for use in a solar cell and a solar cell module, which can endure a severe environment over a long period, in particular which can improve environmental resistance such as hydrolysis resistance or weather resistance and dimensional resistance, and in addition which excels in various characteristics such as heat resistance, moisture resistance, gas barrier characteristics, physical strength, and which can be produced at a very low cost.

Since the back surface protective sheet of the present invention excels in dimensional resistance, wiring does not bend during production of a solar cell module, a solar cell does not shift, and further, since a thermal fixing step in the conventional stretching film can be omitted by using a non-oriented PBT as a back surface protective sheet, film-forming equipment is not limited, and a back surface protective sheet which excels in dimensional resistance can be produced at a very low cost, and as a result, it is possible to magnify the size of a solar cell module and to reduce the cost. In addition, since the back surface protective sheet of the present invention uses no aluminum foil and fluorine film as a constitutive material, it is possible to provide a back surface protective sheet for use in a solar cell having few environmental stresses, taking into consideration the environment such as waste after use, safety, etc.

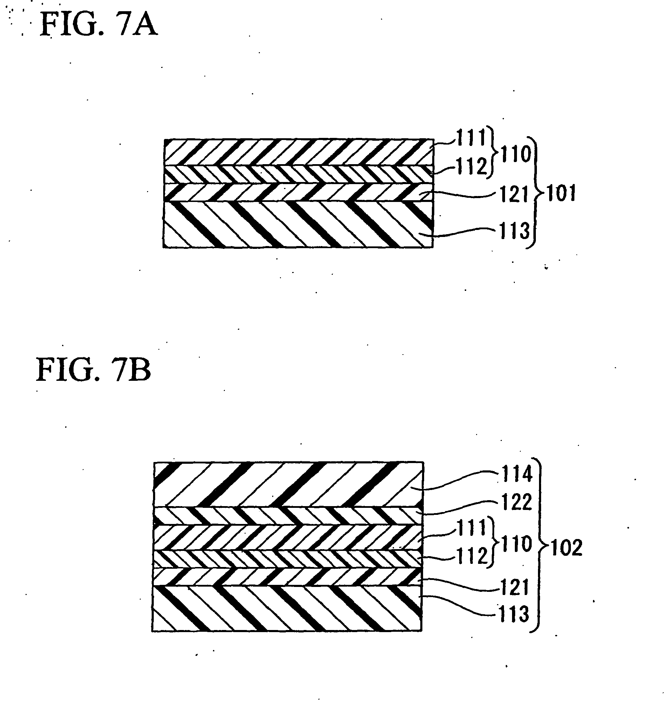

A detailed explanation will be given below with respect to the back surface protective sheet for use in a solar cell of the present invention and a solar cell module using the same, according to the preferred embodiment. FIG. 7A is a side sectional view showing one embodiment of the back surface protective sheet for use in a solar cell of the present invention, and a back surface protective sheet (101) for use in a solar cell has a constitution which consists of a gas barrier laminated film (110) consisting of a base material layer (111) and an inorganic oxide evaporated thin film layer (112) laminated onto one surface of the base material layer (111), and a non-oriented polybutyleneterephthalate film layer (113) laminated onto the evaporated thin film layer (112) surface, while inserting an adhesive layer (121) therebetween. FIG. 7B a side sectional view showing another embodiment of the back surface protective sheet for use in a solar cell of the present invention, and a back surface protective sheet (102) for use in a solar cell has a constitution which consists of a gas barrier laminated film (110) consisting of a base material layer (111) and an inorganic oxide evaporated thin film layer (112) laminated onto one surface of the base material layer (111), and a non-oriented polybutyleneterephthalate film layers (113, 114) laminated onto both surfaces of the gas barrier laminated film (110) respectively, while inserting adhesive layers (121, 122) therebetween, respectively.

In addition, the gas barrier laminated film (110) may further have a gas barrier coated layer laminated onto the evaporated thin film layer (112), and the gas barrier coated layer as such is preferably those that contain a polyvinyl alcohol, one or more of metal alkoxide and hydrolysate thereof, of which the thickness after drying preferably ranges from approximately 0.1 to 10 µm.

The base material layer (111) consists of films having heat resistance, for example, polyester type films such as polyethylene terephthalate (PET), polyethylene naphthalate (PEN), etc.; engineering plastics such as a polyamide type film, a polycarbonate film, a polyacrylonitrile film, a polyimide film, etc. are exemplary. Of these, a film biaxially oriented is preferable, a biaxially-oriented nylon film, a biaxially-oriented polyester film are preferable, in particular, a biaxially-oriented polyester film is more preferable. The thickness of the film is not particularly limited, however in general it preferably ranges from 6 to 30 µm.

The evaporated thin film layer (112) consists of aluminum oxide, silicon oxide or a mixture thereof, and excels in gas barrier characteristics and moisture resistance. The thickness of the film preferably ranges from 5 to 300 nm, and the value is suitably selected. However, if the thickness of the film is less than 5 nm, then a uniform film may not be obtained or the thickness of the film may not be sufficient, and as a result it may not serve as a gas barrier material sufficiently. Whereas if the thickness of the film is more than 300 nm, then the thin film may not maintain flexibility, and as a result there is a possibility that cracks may be generated in the thin film due to outer factors such as bending, stretching after film formation. Preferably the thickness ranges from 10 to 150 nm.

As a method for forming the evaporated thin film layer (112), an ordinary vacuum deposition method can be used, another method for forming a thin film layer such as a sputtering method, an ion plating method, a plasma vapor deposition method (CVD), etc. can also be used. However, taking into consideration productivity, a vacuum deposition method is the most excellent at present.

As the non-oriented polybutyleneterephthalate film layer (113,114), a transparent film or a white film having a crystallinity of not less than 20%, and thermal shrinkage percentage with respect to both the longitudinal direction of the film and width direction of the film of not more than 1.2 % can be used, and it may be either a monolayer film or multi-layer co-extrusion film. In order to increase electrical efficiency, a white film is preferable. If the crystallinity is less than 20%, then it will easily shrink, and if the thermal shrinkage percentage with respect to both the longitudinal direction of the film and width direction of the film is not less than 1.2%, then shrinkage will be large, and dimensional resistance will deteriorate. As a process for producing a white film, various methods are present, for example, a process including performing film formation by processing a mixed resin in which a compounded composition consisting of white pigments such as titanium oxide, silica, alumina, calcium carbonate, barium sulfate, etc., or further carbon black in addition to the white pigments is mixed with a polybutyleneterephthalate resin at a predetermined percentage, using a well-known T-die method or an inflation method, or a method of forming a foaming layer to form a white layer can be used. The thickness is suitably selected within a range of 25 to 250 sun, depending on the required quality.

It should be noted that the thermal shrinkage percentage in the above indicates a shrink percentage which is obtained by marking specific reference lines beforehand onto a film-like test piece, measuring the length between the reference lines, and then allowing the test piece to stand in an atmosphere at 150°C for 30 minutes, and thereafter measuring again the length between the reference lines.

The adhesive to be used as the adhesive layers (121, 122) is required not to cause deterioration of adhering strength even after outdoor use for a long period, not to cause delamination, and not to cause yellowing of adhesive, and polyurethane type adhesive can be used. The applied amount thereof preferably ranges from 1 to 5g/m² (dry condition).

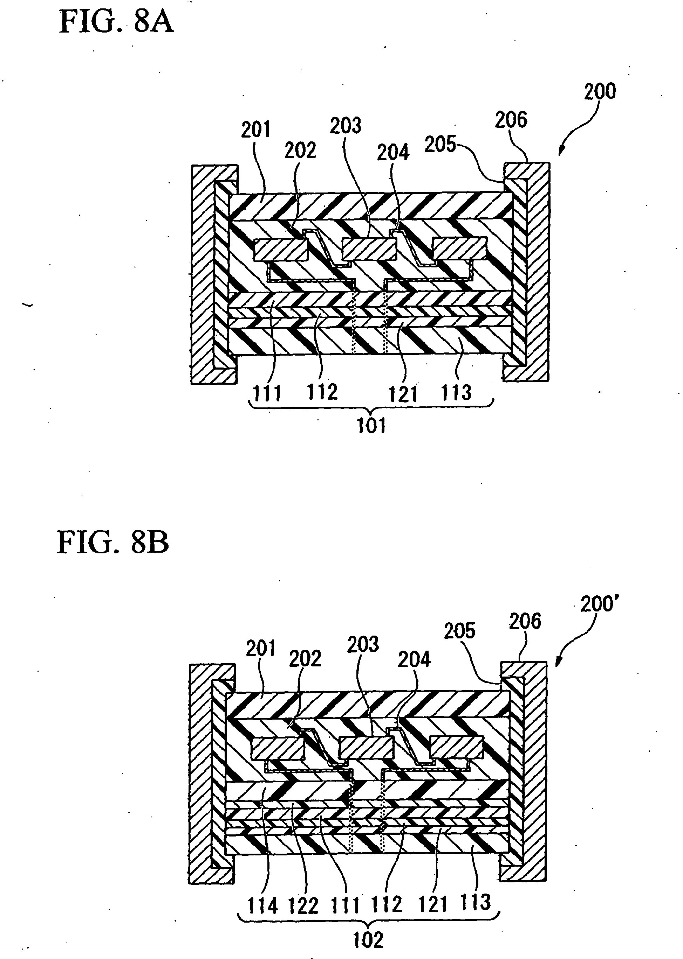

FIG 8A is a cross-sectional view showing an embodiment of a solar cell module which is unitized using the back surface protective sheet for use in a solar cell of the present invention, and FIG 8B is a cross-sectional view showing another embodiment of a solar cell module which is unitized using the back surface protective sheet for use in a solar cell of the present invention. A solar cell module (200) is constituted from an upper transparent material (201), a filler (202), a solar cell element (203), a wiring (204), a back surface protective sheet (101) for use in a solar cell, a sealing material (205) and a frame (206), the back surface protective sheet (101) for use in a solar cell being disposed such that a non-oriented polybutyleneterephthalate film layer (113) surface is outside. The solar cell module (200') uses a back surface protective sheet (102) for use in a solar cell, and the back surface protective sheet (102) for use in a solar cell is disposed such that a non-oriented polybutyleneterephthalate film layer (113) surface is outside. Therefore, in the solar cell module, wiring does not bend, and the solar cell element does not shift, during production of the module. In addition, the solar cell module is hardly hydrolyzed by water outside, free from strength deterioration and crack formation, and hence it is possible to reduce cost.

The upper transparent material (201) should have various characteristics such as an excellent light permeability, an excellent weather resistance over a long period (for approximately 20 years), a low decreasing of light permeability, resistance to dust to be adhered, difficulty of scratches to be formed, a very low steam permeability, etc., and hence, glass, acryl resin, polycarbonate resin, silicone resin, fluorine type resin, etc. are used.

The filler (202) should have various characteristics such as an excellent sunlight permeability, no change in physical properties such as deterioration of light permeability even after allowing to stand outdoors for a long period, excellent insulation properties, no corrosivity to other materials, absence of causing cracks and interface peeling of resin due to a rapid change of outside air conditions, etc., and hence, polybutyral resin, silicone resin, vinyl chloride resin, polyurethane resin, ethylene-vinyl chloride copolymer resin, etc. can be used.

The sealing material (205) is not particularly limited, as long as it can seal, for example, butyl rubber (isobutylene-isoprene rubber), etc. can be used.
As the frame (206), an aluminum frame is generally used.
An explanation of an example of a process for producing a solar cell module of the present invention will be given below. A solar cell element (203) to which wiring has been connected beforehand is inserted between two pieces of a filler sheet having a thickness of 300 µm consisting of ethylene-vinyl acetate copolymer resin into a sandwich fashion, and then an upper transparent material (201) consisting of tempered glass is placed onto one of the filler material sheets, and on the other filler material sheet a back surface protective sheet for use in a solar cell is placed such that a non-oriented polybutyleneterephthalate film layer surface is outside, and thereafter the resultant product is preliminarily heated at 40°C for 5 minutes, and further the product is completely pressed at 150°C for 30 minutes under a reduced pressure from both sides to melt and unify the back surface protective sheet for use in a solar cell, and then end parts thereof are sealed with butyl rubber, and thereafter fixed with an aluminum frame (206) to produce a solar cell module.

An explanation with respect to the back surface protective sheet for use in a solar cell of the present invention will be given below, in accordance with specific Examples, however, the present invention is not limited to these Examples.

### [Example 16]

Onto one surface of a biaxially oriented polyester film having a thickness of 12 µm as a base material layer (111), an evaporated thin film layer (112) consisting of aluminum oxide having a thickness of 50 µm was laminated to produce a gas barrier laminated film (110), and then as an adhesive layer (121) an adhesive consisting of polyurethane type adhesive made by TAKEDA YAKUHIN KOGYO Co., Ltd. (base resin:TAKERACK A511/harder: TAKENATE A50 = 10/1 solution) having an applied amount of 5 g /m²(dry condition) was laminated onto the evaporated thin film layer (112) surface of the resultant gas barrier laminated film (110), and as a non-oriented polybutyleneterephthalate film layer(113) a transparent non-oriented polybutyleneterephthalate film formed by a T-die method having a crystallinity of 26%, a thermal shrinkage percentage with respect to longitudinal direction of film of 0.2 %, a thermal shrinkage percentage with respect to width direction of film of 0.1%, and a thickness of 50 µm was laminated thereon to produce a back surface protective sheet for use in a solar cell of the present invention.

### [Example 17]

A back surface protective sheet for use in a solar cell of the present invention was produced by the same way as in Example 16, with the exception of using a white non-oriented polybutyleneterephthalate film formed by a T-die method having a crystallinity of 23%, a thermal shrinkage percentage with respect to the longitudinal direction of the film of 0.5 %, a thermal shrinkage percentage with respect to the width direction of the film of 0.3%, and a thickness of 50 µm as a non-oriented polybutyleneterephthalate film layer (113).

### [Example 18]

A back surface protective sheet for use in a solar cell of the present invention was produced by the same way as in Example 16, with the exception of using a non-oriented foaming polybutyleneterephthalate film formed by a T-die method having a crystallinity of 22%, a thermal shrinkage percentage with respect to the longitudinal direction of the film of 0.5 %, a thermal shrinkage percentage with respect to the width direction of the film of 0.3%, and a thickness of 75 µm as a non-oriented polybutyleneterephthalate film layer (113).

### [Example 19]

A back surface protective sheet for use in a solar cell of the present invention was produced by the same way as in Example 16, with the exception of using a non-oriented foaming polybutyleneterephthalate film (constitution: a transparent polybutyleneterephthalate resin/a white polybutyleneterephthalate resin/ a transparent polybutyleneterephthalate resin) formed by a three-layer co-extrusion method having a crystallinity of 26%, a thermal shrinkage percentage with respect to the longitudinal direction of the film of 0.3 %, a thermal shrinkage percentage with respect to the width direction of the film of 0.2%, and a thickness of 100 µm as a non-oriented polybutyleneterephthalate film layer (113).

### [Example 20]

A back surface protective sheet for use in a solar cell of the present invention was produced by the same way as in Example 16, with the exception of using a non-oriented polybutyleneterephthalate film formed by an inflation method having a crystallinity of 25%, a thermal shrinkage percentage with respect to the longitudinal direction of the film of 0.3 %, a thermal shrinkage percentage with respect to the width direction of the film of 0.2%, and a thickness of 50 µm as a non-oriented polybutyleneterephthalate film layer (113).

### [Example 21]

A back surface protective sheet for use in a solar cell of the present invention was produced by the same way as in Example 16, with the exception of using a white non-oriented polybutyleneterephthalate film formed by an inflation method having a crystallinity of 25%, a thermal shrinkage percentage with respect to the longitudinal direction of the film of 0.3 %, a thermal shrinkage percentage with respect to the width direction of the film of 0.2%, and a thickness of 50 µm as a non-oriented polybutyleneterephthalate film layer (113).

### [Example 22]

A back surface protective sheet for use in a solar cell of the present invention was produced by the same way as in Example 16, except that as an adhesive layer (121) an adhesive consisting of polyurethane type adhesive made by TAKEDA YAKUHIN KOGYO Co., Ltd. (base resin:TAKERACK A511/harder: TAKENATE A50 = 10/1 solution) having an applied amount of 5 g /m² (dry condition) was laminated onto the evaporated thin film layer (112) surface of the resultant gas barrier laminated film (110), and as a non-oriented polybutyleneterephthalate film layer (113) a transparent non-oriented polybutyleneterephthalate film formed by a T-die method having a crystallinity of 24%, a thermal shrinkage percentage with respect to the longitudinal direction of the film of 0.3 %, a thermal shrinkage percentage with respect to the width direction of the film of 0.2%, and a thickness of 50 µm was laminated thereon, as an adhesive layer (122) an adhesive consisting of the same components having an applied amount of 5 g /m²(dry condition) was laminated onto a base material layer (111) surface, and as a non-oriented polybutyleneterephthalate film layer (114) a white non-oriented polybutyleneterephthalate film formed by a T-die method having a crystallinity of 24%, a thermal shrinkage percentage with respect to the longitudinal direction of the film of 0.3 %, a thermal shrinkage percentage with respect to the width direction of the film of 0.2%, and a thickness of 50 µm was laminated thereon.

An explanation will be given below, with respect to Examples for comparison of the present invention.

### [Example 23]

A back surface protective sheet for comparison was produced by the same way as in Example 16, with the exception of using a white biaxially oriented polyethyleneterephthalate film formed by a T-die method having a thermal shrinkage percentage with respect to the longitudinal direction of the film of 1.5%, a thermal shrinkage percentage with respect to the width direction of the film of 1%, and a thickness of 50 µm instead of the non-oriented polybutyleneterephthalate film.

### [Example 24]

A back surface protective sheet for comparison was produced by the same way as in Example 16, with the exception of using a transparent heat-resistant biaxially oriented polyethyleneterephthalate film formed by a T-die method having a thermal shrinkage percentage with respect to the longitudinal direction of the film of 1.5%, a thermal shrinkage percentage with respect to the width direction of the film of 0.7%, and a thickness of 50 µm instead of the non-oriented polybutyleneterephthalate film.

### [Example 25]

A back surface protective sheet for comparison was produced by the same way as in Example 16, with the exception of using a biaxially oriented polyethyleneterephthalate film formed by a T-die method having a thermal shrinkage percentage with respect to the longitudinal direction of the film of 0.5%, a thermal shrinkage percentage with respect to the width direction of the film of 0.4%, and a thickness of 12 µm instead of the gas barrier laminated film.

### <Evaluation> .

Whether it is good or bad with respect to hydrolysis resistance of each of non-oriented polybutylene terephthalate films and biaxially oriented polyethyleneterephthalate films used in the back surface protective sheet for use in a solar cell of the present invention in Examples 16 to 22 and the back surface protective sheet for use in a solar cell for comparison in Examples 23 to 25 was measured by the following method to be evaluated, and electrical output characteristics of the solar cell module unitized using the back surface protective sheet for use in a solar cell were measured and evaluated. The evaluation results are shown in Table 2.

### (1) Hydrolysis resistance

The non-oriented polybutyleneterephthalate films and the biaxially oriented polyethyleneterephthalate films used in each of the back surface protective sheets were allowed to stand under the condition of 85°C, 85%RH for 1,000 hours. Breaking strength of the film before and after being allowed to stand was measured to obtain a ratio (retention) when the breaking strength before being allowed to stand was regarded as 100%, and the case in which retention is not less than 70% is evaluated to be "A: OK", the case in which retention ranges from 50 to 70% is evaluated to be "B", and the case in which retention is less than 50% is evaluated to be "C: NG".

### (2) Electric output characteristics

The produced solar cell module was allowed to stand under a condition of 85 85%RH for 1,000 hours, and thereafter, retention to the initial electric output thereof was measured by the method in accordance with JIS C-8913.

**[Table 2]**

| Kind | Example No. | Whether it is good or poor with respect to hydrolysis resistance of each of non-oriented polybutylene terephthalate film (PBT) and biaxially oriented polyethyleneterephtalate film (PET) used in the back surface protective sheet for use in a solar cell | | Retention to the initial electric output after being allowed to stand under a condition of 85°C, 85%RH for 1,000 hours (%) |
|---|---|---|---|---|
| | | PBT | PET | |
| The Present Invention | Example 16 | A | - | 97.5 |
| | Example 17 | A | - | 98.2 |
| | Example 18 | A | - | 100 |
| | Example 19 | A | - | 97.4 |
| | Example 20 | A | - | 99.1 |
| | Example 21 | A | - | 98.2 |
| | Example 22 | A | - | 98.5 |
| Comparative Example | Example 23 | - | C | 92.1 |
| | Example 24 | - | B | 96.2 |
| | Examples 25 | - | B | 87 |

| | | | | |
|---|---|---|---|---|
| A= OK: retention is not less than 70% B= : retention ranges 50 to 70% C= NG: retention is not more than 50% | | | | |

As shown in Table 2, all of the non-oriented polybutyleneterephthalate films used in the back surface protective sheet for use in a solar cell of the present invention in Examples 16 to 22 excel in hydrolysis resistance, and all of the solar cell modules unitized using the back surface protective sheet for use in a solar cell excel in retention of electric output even after being allowed to stand. On the other hand, the biaxially oriented polyethyleneterephthalate film used in the back surface protective sheet for use in a solar cell for comparison in Example 23 is poor in hydrolysis resistance, and the solar cell module unitized using the back surface protective sheet for use in a solar cell is poor in retention of electric output after being allowed to stand. In addition, the biaxially oriented polyethyleneterephthalate film used in the back surface protective sheet for use in a solar cell for comparison in Example 24 is slightly poor in hydrolysis resistance, and the solar cell module unitized using the back surface protective sheet for use in a solar cell for comparison in Example 25 is particularly poor in retention of the electric output after being allowed to stand.

### (Examples 26 to 32)

Next, evaporation was performed onto a PBT film as a back sheet of a solar cell module, and the resultant evaporated PBT film was adhered to obtain a test piece. Using the test piece, a measurement was performed on the following Examples and Comparative Examples in order to examine the performance of the test piece having a constitution as such.

### [Example 26]

Al₂O₃ (aluminum oxide: alumina) was vaporized in a vacuum and deposited onto a PBT film having a thickness of 38 µm to obtain a transparent evaporated film.
A urethane type adhesive (made by MITSUI-TAKEDA CHEMICAL Co., Ltd. base resin:TAKERACK A515/harder: A50 = 10/1) was applied in an applied amount of 5 g/m² onto an evaporated surface of the transparent evaporated film and then the resultant film was adhered to a PBT film having a thickness of 38 µm to obtain a back sheet. Using this back sheet, as shown in FIG. 7A, a glass plate, an EVA, a solar cell element, an EVA, and the back sheet were stacked in this order, and then the resultant stacked material was laminated by performing a vacuum heating at a condition of 150 °C -10 minutes-1 atom to obtain a solar cell module for a test. Similarly, each of test samples of Examples 28 to 32 was prepared using the constitutions shown in Table 3.

### (Comparative Example 2)

A urethane type adhesive was applied to a fluorine film (TEDLAR(trade mark) made by DUPONT Co., Ltd.) with an applied amount of 5 g/m² and was adhered to an aluminum foil having a thickness of 20 µm, and similarly an adhesive was applied to an aluminum foil and adhered to a fluorine film to obtain a back sheet having a three-layer constitution of a fluorine film having a thickness of 38 µm/an Al foil having a thickness of 20 µm/a fluorine film having a thickness of 38 µm.
Using this back sheet, a solar cell module for a test was obtained by the same way as in Example 26.

### (Comparative Example 3)

A urethane type adhesive (made by MITSUI-TAKEDA CHEMICAL Co., Ltd. base resin:TAKERACK A515/harder: A50 = 10/1) was applied to an evaporated surface of a transparent evaporated PET film (GL-AEH made by TOPPAN PRINTING Co., Ltd.) having a thickness of 12 µm with an applied amount of 5 g/m² and adhered to a polyethyleneterephthalate (PET) film (S10 made by TORAY Co., Ltd.) to obtain a back sheet. Using this back sheet, a solar cell module for a test was obtained by the same way as in Example 26.

### (Comparative Example 4)

A urethane type adhesive (made by MITSUI-TAKEDA CHEMICAL Co., Ltd. base resin:TAKERACK A515/harder: A50 = 10/1) was applied to an evaporated surface of a transparent evaporated PET film (GL-AEH made by TOPPAN PRINTING Co.,Ltd.) having a thickness of 12 µm with an applied amount of 5 g/m² and adhered to a PBT film having a thickness of 38 µm, and a urethane type adhesive (made by MITSUI-TAKEDA CHEMICAL Co., Ltd. base resin:TAKERACK A515/harder: A50 = 10/1) was further applied to a GL film surface of the two-layer laminated film with an applied amount of 5 g/m² and adhered to a PBT film having a thickness of 38 µm to obtain a back sheet. Using this back sheet, a solar cell module for a test was obtained by the same way as in Example 26.
A test was performed using these samples. The results are shown in Table 3. It should be noted that the test method is the same as in the above Examples.

**Table 3**

| Kind | No. | The first layer | The second layer | The third layer | Film forming method | Crystallinity (%) | Thermal shrinkage percentage (%) | | Hydrolysis resistance | Moisture resistance | Solar cell output retention (%) |
|---|---|---|---|---|---|---|---|---|---|---|---|
| | | | | | | | MD | TD | | | |
| Examples | 26 | Transparent PBT38 | Alumina Evaporated transparent PBT38 | - | T-die method | 26 | 0.5 | 0.2 | A | 0.5 | 98.3 |
| | 27 | White pigment kneaded PBT50 | Alumina Evaporated transparent PBT20 | - | ↑ | 24 | 0.6 | 0.3 | A | 0.5 | 99.0 |
| | 28 | Foaming PBT100 | Alumina Evaporated transparent PBT50 | - | ↑ | 22 | 0.5 | 0.6 | A | 0.3 | 99.3 |
| | 29 | Transparent PBT38 | Alumina Evaporated transparent PBT20 | White pigment kneaded PBT38 | ↑ | 24 | 0.6 | 0.2 | A | 0.5 | 98.5 |
| | 30 | Co-extrusion PBT100* | Alumina Evaporated transparent PBT20 | - | ↑ | 26 | 0.4 | 0.2 | A | 0.6 | 97.4 |
| | 31 | PBT50 | Silica Evaporated transparent PBT20 | - | Inflation method | 25 | 0.3 | 0.2 | A | 0.3 | 99.1 |
| | 32 | Transparent PBT188 transparent | Alumina Evaporated PBT20 | White PET50 | T-die method | 24 | 0.6 | 0.2 | A | 0.5 | 98.5 |
| Comparative Examples | 1 | White PET50 | Alumina Evaporated transparent PBT12 | - | T-die biaxially oriented | - | 1.5 | 1.0 | C | 0.8 | 92.1 |
| | 2 | Heat resistant PET50 | Alumina Evaporated transparent PBT12 | - | T-die biaxially oriented | - | 1.5 | 0.7 | B | 0.6 | 96.2 |
| | 3 | TEDLER38 | PET 75 | TEDLER38 | T-die method | - | 1.5 | 1.0 | A | 6.5 | 93.0 |

| | | | | | | | | | | | |
|---|---|---|---|---|---|---|---|---|---|---|---|
| A= OK: retention is not less than 70% B= : retention ranges 50 to 70% C= NG: retention is not more than 50% | | | | | | | | | | | |

From the results shown in Table 3, the following observation is obtained. In each of Comparative Examples 1 and 2 using a PET film as the first layer, hydrolysis resistance is inferior to Examples 26 to 31, thermal shrinkage percentage is high, there is a problem in dimensional resistance, and wiring shift easily occurs. In Comparative Example 3, hydrolysis resistance is equivalent, however, moisture resistance is poor, retention of a solar cell output is poor, and there is a problem in generation efficiency.

### INDUSTRIAL APPLICABILITY

The present invention can be applied to a back surface protective sheet for solar cells which can endure a severe environment over a long period, in particular which can improve environmental resistance such as hydrolysis resistance or weather resistance and dimensional resistance, in addition which excels in various characteristics such as heat resistance, moisture resistance, gas barrier characteristics, physical strength, and which can be produced at a very low cost.

## Claims

1. A back surface protective sheet for use in a solar cell, comprising a terephthalate film (1), an adhesive layer disposed onto the terephthalate film (1), and a gas barrier evaporated film (2) having an evaporated layer formed by evaporating an inorganic oxide (2c) onto a base material (2a), wherein the gas barrier evaporated film is disposed on a solar cell element side; **characterised in that** film (1) is a non-oriented transparent polybutylene terephthalate film.

2. The back surface protective sheet for use in a solar cell as set forth in claim 1, wherein the non-oriented transparent polybutylene terephthalate film (1) has at least a thermal shrinkage percentage of not more than 1.2% with respect to both a longitudinal direction of the film and width direction of the film.

3. The back surface protective sheet for use in a solar cell as set forth in claim 1, wherein the non-oriented transparent polybutylene terephthalate film (1) has a crystallinity of not less than 20%, and a thermal shrinkage percentage of not more than 1.2% with respect to both a longitudinal direction of the film and width direction of the film.

4. The back surface protective sheet for use in a solar cell as set forth in any one of claims 1 to 3, wherein the base material (2a) is a non-oriented transparent polybutylene terephthalate film.

5. The back surface protective sheet for use in a solar cell as set forth in any one of claims 1 to 3, wherein the gas barrier evaporated film (2) further has a plastic film (3) which is disposed onto a solar cell element side.

6. The back surface protective sheet for use in a solar cell as set forth in any one of claims 1 to 3, wherein the evaporated film (2) is made of a mixture of one or more selected from the group consisting of aluminum oxide, silicon oxide and magnesium oxide.

7. The back surface protective sheet for use in a solar cell as set forth in claim 5, wherein the plastic film (3) is a non-oriented transparent polybutylene terephthalate film having a thermal shrinkage percentage of not more than 1.2% with respect to both the longitudinal direction of the film and the width direction of the film.

8. The back surface protective sheet for use in a solar cell as set forth in any one of claims 1 to 3, wherein the non-oriented transparent polybutylene terephthalate film (1) contains an additive for coloration.

9. The back surface protective sheet for use in a solar cell as set forth in any one of claims 1 to 3, wherein the non-oriented transparent polybutylene terephthalate film (1) contains a coloring additive for whitening.

10. The back surface protective sheet for use in a solar cell as set forth in any one of claims 1 to 3, wherein the non-oriented transparent polybutylene terephthalate film (1) has a foaming layer therein and a white (opaque) appearance.

11. The back surface protective sheet for use in a solar cell as set forth in any one of claims 1 to 3, wherein the non-oriented transparent polybutylene terephthalate film (1) contains a black coloring additive.

12. A solar cell module comprising the back surface protective sheet for use in a solar cell as set forth in any one of claims 1 to 3.

13. A solar cell module comprising the back surface protective sheet for use in a solar cell as set forth in any one of claims 1 to 3, wherein the back surface protective sheet is unitized such that the non-oriented polybutylene terephthalate film surface of the back surface protective sheet for use in a solar cell is arranged outside.

## Patentansprüche

1. Rückseitenschutzlage zur Verwendung in einer Solarzelle, der einen Terephthalatfilm (1), eine Haftschicht, die auf dem Terephthalatfilm (1) angeordnet ist, und einen Gassperraufdampffilm (2) mit einer aufgedampften Schicht gebildet durch Aufdampfen eines anorganischen Oxids (2c) auf ein Grundmaterial (2a) umfasst, wobei der Gassperraufdampffilm auf einer Solarzellenelementseite angeordnet ist; **dadurch gekennzeichnet, dass** Film (1) ein nicht-orientierter transparenter Polybutylenterephthalatfilm ist.

2. Rückseitenschutzlage zur Verwendung in einer Solarzelle nach Anspruch 1, wobei der nicht-orientierte transparente Polybutylenterephthalatfilm (1) zumindest eine prozentuale thermische Schrumpfung von nicht mehr als 1,2% mit Bezug auf sowohl eine longitudinale Richtung des Films als auch eine Breitenrichtung des Films aufweist.

3. Rückseitenschutzlage zur Verwendung in einer Solarzelle nach Anspruch 1, wobei der nicht-orientierte transparente Polybutylenterephthalatfilm (1) eine Kristallinität von nicht weniger als 20% und eine prozentuale thermische Schrumpfung von nicht mehr als 1,2% mit Bezug auf sowohl eine longitudinale Richtung des Films als auch eine Breitenrichtung des Films aufweist.

4. Rückseitenschutzlage zur Verwendung in einer Solarzelle nach einem der Ansprüche 1 bis 3, wobei das Grundmaterial (2a) ein nicht-orientierter transparenter Polybutylenterephthalatfilm ist.

5. Rückseitenschutzlage zur Verwendung in einer Solarzelle nach einem der Ansprüche 1 bis 3, wobei der Gassperraufdampffilm (2) ferner einen Kunststofffilm (3) aufweist, welcher auf einer Solarzellenelementseite angeordnet ist.

6. Rückseitenschutzlage zur Verwendung in einer Solarzelle nach einem der Ansprüche 1 bis 3, wobei der Aufdampffilm (2) aus einer Mischung aus einem oder mehreren ausgewählt aus der Gruppe bestehend aus Aluminiumoxid, Siliziumoxid und Magnesiumoxid hergestellt ist.

7. Rückseitenschutzlage zur Verwendung in einer Solarzelle nach Anspruch 5, wobei der Kunststofffilm (3) ein nicht-orientierter transparenter Polybutylenterephthalatfilm mit einer prozentualen thermischen Schrumpfung von nicht mehr als 1,2% mit Bezug auf sowohl die longitudinale Richtung des Films als auch die Breitenrichtung des Films ist.

8. Rückseitenschutzlage zur Verwendung in einer Solarzelle nach einem der Ansprüche 1 bis 3, wobei der nicht-orientierte transparente Polybutylenterephthalatfilm (1) ein Additiv zur Farbgebung enthält.

9. Rückseitenschutzlage zur Verwendung in einer Solarzelle nach einem der Ansprüche 1 bis 3, wobei der nicht-orientierte transparente Polybutylenterephthalatfilm (1) ein färbendes Additiv zum Weißen enthält.

10. Rückseitenschutzlage zur Verwendung in einer Solarzelle nach einem der Ansprüche 1 bis 3, wobei der nicht-orientierte transparente Polybutylenterephthalatfilm (1) darin eine Schäumschicht und eine weiße (opake) Erscheinung aufweist.

11. Rückseitenschutzlage zur Verwendung in einer Solarzelle nach einem der Ansprüche 1 bis 3, wobei der nicht-orientierte transparente Polybutylenterephthalatfilm (1) ein Schwarzfärbendes Additiv enthält.

12. Solarzellenmodul, das die Rückseitenschutzlage zur Verwendung in einer Solarzelle nach einem der Ansprüche 1 bis 3 umfasst.

13. Solarzellenmodul, das die Rückseitenschutzlage zur Verwendung in einer Solarzelle nach einem der Ansprüche 1 bis 3 umfasst, wobei die Rückseitenschutzlage so modularisiert ist, dass die Oberfläche des nichtorientierten Polybutylenterephthalatfilms der Rückseitenschutzlage zur Verwendung in einer Solarzelle Außen angeordnet ist.

## Revendications

1. Feuille de protection de face arrière à utiliser dans une cellule solaire, comprenant un film en téréphtalate (1), une couche adhésive disposée sur le film en téréphtalate (1), et un film évaporé (2) de barrière contre les gaz ayant une couche évaporée formée en faisant évaporer un oxyde inorganique (2c) sur un matériau de base (2a), où le film évaporé de barrière contre les gaz est disposé sur un côté d'un élément de la cellule solaire; **caractérisé en ce que** le film (1) est un film en poly(téréphtalate de butylène) transparent non orienté.

2. Feuille de protection de face arrière à utiliser dans une cellule solaire selon la revendication 1, dans laquelle le film (1) en poly(téréphtalate de butylène) transparent non orienté a au moins un pourcentage de rétrécissement thermique qui ne dépasse pas 1,2% par rapport à la direction longitudinale du film et à la direction de largeur du film.

3. Feuille de protection de face arrière à utiliser dans une cellule solaire selon la revendication 1, dans laquelle le film (1) en poly(téréphtalate de butylène) transparent non orienté a une cristallinité qui n'est pas inférieure à 20%, et un pourcentage de rétrécissement thermique qui ne dépasse pas 1,2% par rapport à la direction longitudinale du film et à la direction de largeur du film.

4. Feuille de protection de face arrière à utiliser dans une cellule solaire selon l'une quelconque des revendications 1 à 3, dans laquelle le matériau de base (2a) est un film en poly(téréphtalate de butylène) transparent non orienté.

5. Feuille protection de face arrière à utiliser dans une cellule solaire selon l'une quelconque des revendications 1 à 3, dans laquelle le film (2) évaporé de barrière contre les gaz a en outre un film plastique (3) qui est disposé sur un côté d'un élément de la cellule solaire.

6. Feuille de protection de face arrière à utiliser dans une cellule solaire selon l'une quelconque des revendications 1 à 3, dans laquelle le film évaporé (2) est fait d'un mélange d'un ou de plusieurs éléments sélectionnés du groupe constitué d'oxyde d'aluminium, d'oxyde de silicium et d'oxyde de magnésium.

7. Feuille de protection de face arrière à utiliser dans une cellule solaire selon la revendication 5, dans laquelle le film plastique (3) est un film en poly(téréphtalate de butylène) transparent non orienté ayant un pourcentage de rétrécissement thermique qui ne dépasse pas 1,2% par rapport à la direction longitudinale du film et à la direction de largeur du film.

8. Feuille de protection de face arrière à utiliser dans une cellule solaire selon l'une quelconque des revendications 1 à 3, dans laquelle le film (1) en poly(téréphtalate de butylène) transparent non orienté contient un additif pour la coloration.

9. Feuille de protection de face arrière à utiliser dans une cellule solaire selon l'une quelconque des revendications 1 à 3, dans laquelle le film (1) en poly(téréphtalate de butylène) transparent non orienté contient un additif de coloration pour le blanchiment.

10. Feuille de protection de face arrière à utiliser dans une cellule solaire selon l'une quelconque des revendications 1 à 3, dans laquelle le film (1) en poly(téréphtalate de butylène) transparent non orienté a une couche de moussage à l'intérieur et un aspect (opaque) blanc.

11. Feuille de protection de face arrière à utiliser dans une cellule solaire selon l'une quelconque des revendications 1 à 3, dans laquelle le film (1) en poly(téréphtalate de butylène) transparent non orienté contient un additif de coloration noire.

12. Module de cellule solaire comprenant la feuille de protection de face arrière à utiliser dans une cellule solaire selon l'une quelconque des revendications 1 à 3.

13. Module de cellule solaire comprenant la feuille de protection de face arrière à utiliser dans une cellule solaire selon l'une quelconque des revendications 1 à 3, dans lequel la feuille de protection de face arrière est unifiée de sorte que la surface du film en poly(téréphtalate de butylène) transparent non orienté de la feuille de protection de face arrière à utiliser dans une cellule solaire soit agencée à l'extérieur.
